# EUROPÄISCHE PATENTSCHRIFT

(11) **EP 1 046 920 B1**
(45) Veröffentlichungstag und Bekanntmachung des Hinweises auf die Patenterteilung: **29.12.2004**
(21) Anmeldenummer: 00440095.8
(22) Anmeldetag: 07.04.2000
(51) Int. Cl.: G01R 19/165, H05B 37/03, B61L 5/18

(54) **Schaltungsanordnung zur Strom-Schwellwerterkennung**
Circuit for current threshold detection
Circuit pour la détection de seuils de courant

(30) Priorität: 20.04.1999 DE 19917910
(43) Veröffentlichungstag der Anmeldung: 25.10.2000
(73) Patentinhaber: ALCATEL, 75008 Paris (FR)
(72) Erfinder: Telefont, Heinz, 3500 Krems/Egelsee (AT)
(74) Vertreter: Giebel-Roder, Marion

(56) Entgegenhaltungen:
- EP-A- 0 154 760
- EP-A- 0 490 123
- DE-A- 2 632 929
- DE-A- 3 531 001
- DE-A- 19 536 782
- GB-A- 687 600
- GB-A- 883 660
- US-A- 4 093 977
- US-A- 4 219 807
- US-A- 4 736 138

## Beschreibung

Die Erfindung betrifft eine Schaltungsanordnung zur Strom-Schwellwerterkennung gemäß dem Oberbegriff des Anspruchs 1. Die Strom-Schwellwerterkennung stellt ein grundlegendes Problem schaltungstechnischer Anlagen sehr unterschiedlicher Zielsetzung und Anwendung dar. Aus der Eisenbahnsicherungstechnik sind beispielsweise Schaltungen zur Lampenstrom-Schwellwerterkennung bekannt, bei denen die Energieversorgung aus dem Meßsignal erfolgt. Nachteilig bei diesen Schaltungen ist neben der Abhängigkeit des Eingangsspannungsabfalls der Eigen-Energieversorgung von der Höhe des Meßstroms vor allem die Beschränkung der Anwendbarkeit auf Wechselstrom-Signale. Prinzipiell besteht bei Schwellwerterkennungs-Schaltungen immer das Erfordernis, eine hohe Genauigkeit zu erreichen, wobei Fremdspeisung und Abgleich entbehrlich sein sollen und eine möglichst hochvoltige Spannungstrennung zwischen Meßstrom und Ausgangssignal anzustreben ist.

Der Erfindung liegt die Aufgabe zugrunde, die oben genannten Nachteile zu beseitigen und eine gattungsgemäße Schaltungsanordnung anzugeben, die für Gleich- und Wechselstrom geeignet ist. Des weiteren besteht die Aufgabe, den Eingangsspannungsabfall vom Meßstrom zu entkoppeln.

Erfindungsgemäß wird die erstgenannte Aufgabe mit den kennzeichnenden Merkmalen des Anspruchs 1 gelöst. Die Schaltung zeichnet sich vor allem durch einfachen Aufbau und geringen Bauteilebedarf aus. Ein AC/DC-Meßstrom erzeugt am Meßwiderstand eine AC/DC-Spannung, welche über den Brückengleichrichter am Ladekondensator gespeichert wird. Die daraus resultierende Gleichspannung wird einem DC/DC-Wandler zugeführt, der beispielsweise ab 1V Eingangsspannung eine stabile Ausgangsspannung von +5V erzeugt. Mit diesen 5V wird die Meßschaltung im Sinne einer Eigen-Energieversorgung betrieben. Der DC/DC-Wandler kann dabei ein sogenannter Miniatur DC/DC-Wandler, zum Beispiel des Typs LT1307 von Linear Technology, sein. Die Energieversorgung erfolgt aus dem Meßsignal ohne dieses wesentlich zu beeinflussen. Durch den DC/DC-Wandler wird der Spannungsabfall am Meßwiderstand klein gehalten und es ergibt sich ein relativ weiter Strombereich von typischerweise 50mA bis 20A- abhängig vom jeweils verwendeten Meßwiderstand.

Die Komparatorschaltung gemäß Anspruch 2 ermöglicht einen zuverlässigen Vergleich der hoch stabilen Referenzspannung mit der am Ladekondensator anliegenden und somit ein Maß für die Spannung am Meßwiderstand darstellenden Eingangsspannung. Wird nur eine Gleichstrommessung benötigt, kann der Brückengleichrichter entfallen, wodurch die Schaltung auf eine niedrigere Schaltschwelle eingestellt werden kann.

Um eine Überlastung der Schaltung zu vermeiden, ist gemäß Anspruch 3 eine Begrenzerdiode vorgesehen, die die am Ladekondensator anliegende Spannung auf circa 3V begrenzt.

Anspruch 4 charakterisiert das Grundprinzip zur Lösung der zweiten oben genannten Aufgabe. Damit der Eingangsspannungsabfall der Schaltung unabhängig vom Meßstrom ist, ist eine spezielle Regelschaltung vorgesehen. Auf diese Weise wird die durch den Meßstrom am Meßwiderstand erzeugte Spannung, die prinzipiell sehr variabel sein kann, zur Realisierung der Eigen-Energieversorgung der Meßschaltung quasi geglättet.

Eine für diese Zwecke geeignete Regelschaltung ist durch die Merkmale des Anspruchs 5 charakterisiert. Dabei wird die am Ladekondensator anliegende Spannung auf circa 2V geregelt.

Zum Schutz der Schaltung vor Kurzschlußströmen bis zum Auslösen einer Sicherung im Lastkreis kann gemäß Anspruch 6 zusätzlich eine eingangsseitige bidirektionale Leistungsschutzdiode vorgesehen sein.

Aus Sicherheitsgründen kann eine gelegentliche Überprüfung der Schaltschwelle erforderlich sein. Dazu kann ein schaltbarer Prüfwiderstand gemäß Anspruch 7 parallel zum Meßwiderstand vorgesehen sein.

Ausgangsseitig der Meßschaltung, gegebenenfalls eines Komparators, wird gemäß Anspruch 8 vorzugsweise ein Optokoppler angesteuert, der eine Auswertelektronik beaufschlagt.

Anspruch 9 charakterisiert eine vorteilhafte Ausführungsform, bei der nicht nur kontinuierliche Signale, sondern auch Blinksignale auswertbar sind.

Die Erfindung wird nachfolgend anhand zweier Schaltungsbeispiele näher erläutert. Es zeigen:
- Figur 1: ein erstes Blockschaltbild zur Strom-Schwellwerterkennung mit detailliert dargestellter Meßschaltung und
- Figur 2: ein zweites Blockscheitbild zur Storm-Schwellwerterkennung mit detailliert dargestellter Regelschaltung.

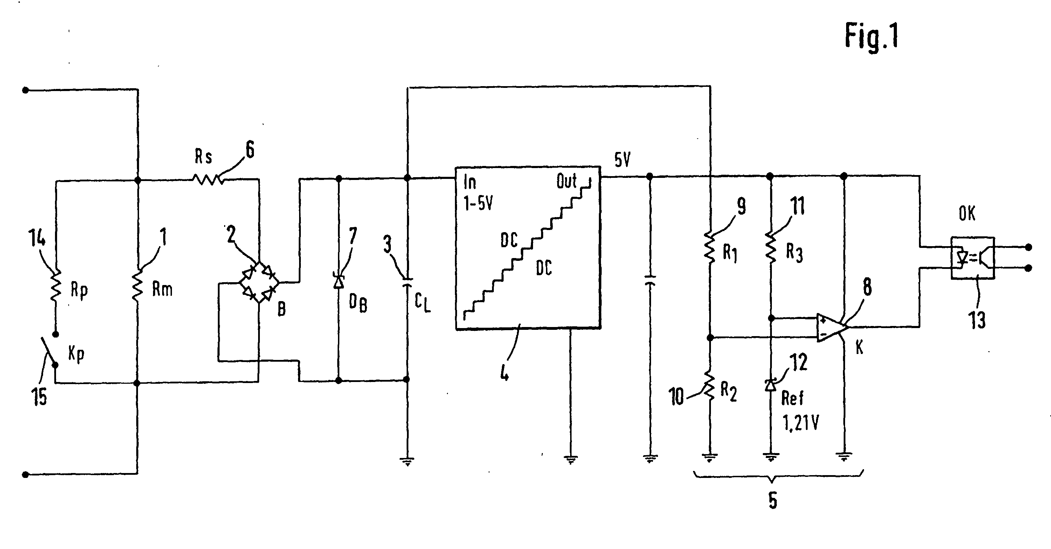

Beide Schaltungen bestehen im wesentlichen aus einem Meßwiderstand Rₘ (1), und einem Brückengleichrichter B (2) dessen Ausgänge auf einen Ladekondensator C_{L} (3) geschaltet sind, welcher sowohl mit einem Miniatur DC/DC-Wandler (4) als auch mit einer Meßschaltung (5) verbunden ist. Ein AC/DC-Meßstrom erzeugt am Meßwiderstand Rₘ (1) eine AC/DC-Spannung, welche gemäß Figur 1 über einen Schutzwiderstand Rₛ (6) und den Brückengleichrichter B (2) am Ladekondensator C_{L} (3) gespeichert wird. Die am Ladekondensator C_{L} (3) anliegende Spannung wird durch eine Begrenzerdiode D_{B} - beispielsweise bei Überstrom (Lampenstromeinschaltspitze) - auf circa 3V begrenzt. Aus dieser Gleichspannung wird der DC/DC-Wandler (4) gespeist, welcher ab 1V Eingangsspannung eine stabile Ausgangsspannung von +5V liefert. Mit diesen 5V wird die Meßschaltung (5) betrieben. Aus Figur 1 ist ersichtlich, daß diese Meßschaltung (5) im wesentlichen einen Komparator K (8) und zwei Spannungsteiler R₁/R₂ (9/10) und R₃/Ref (11/12) umfaßt, wobei mit R₃ (11) und der Referenzdiode Ref (12) eine hoch stabile Referenzspannung von 1,21V erzeugt und mit der am Ladekondensator C_{L} (3) anliegenden Eingangsspannung über R₁/R₂ (9/10) verglichen wird. Der Komparator K (8) wertet eine vorhandene Differenzspannung aus und schaltet über einen Optokoppler Ok (13) eine hier nicht dargestellte Auswerteelektronik ein beziehungsweise aus.

Figur 1 zeigt weiterhin eine Beschaltung des Meßwiderstandes Rₘ (1) mit einem Prüfwiderstand Rₚ (14), der mittels eines Relaiskontaktes Kₚ (15) parallel zum Meßwiderstand Rₘ (1) geschaltet werden kann. Dieser Prüfwiderstand Rₚ (14) dient der Überprüfung der Funktionsfähigkeit der Meßschaltung (5), das heißt der Überprüfung deren Schaltschwelle.

Falls nur eine Gleichstrommessung benötigt wird, kann die Schaltschwelle besonders niedrig eingestellt werden, da dann der Brückengleichrichter W (2) entbehrlich ist.

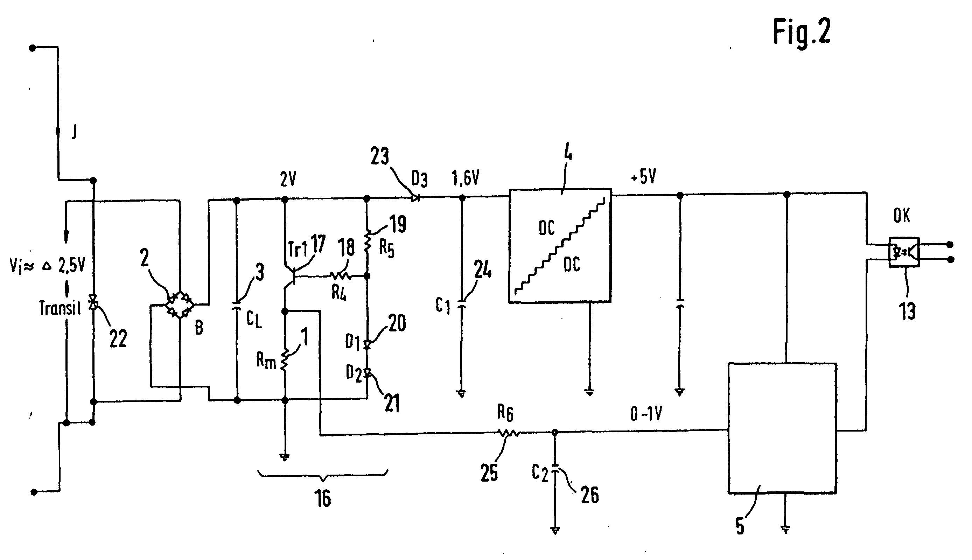

Figur 2 zeigt eine ähnliche Schaltung, wobei hier zusätzlich eine Regelschaltung (16) zur Stabilisierung des Spannungsabfalls an der Meßschaltung (5) vorgesehen ist. Der AC/DC-Meßstrom fließt über den Brückengleichrichter B (2) einen PNP-Transistor Tr1 (17) und den Meßwiderstand Rₘ (1) durch die Meßschaltung (5). Die am Ladekondensator C_{L} (3) anliegende Spannung wird durch die Regelschaltung (16) auf circa 2V geregelt. Der Regelkreis umfaßt neben dem Transistor Tr1 (17) und dem Meßwiderstand Rₘ (1) einen Spannungsteiler R₄/R₅ (18/19), dessen Abgriff über in Serie geschaltete Dioden D₁ (20) und D₂ (21) auf den Meßwiderstand Rₘ (1) zurückgeführt ist.

Am Eingang der Schaltung - vor dem Brückengleichrichter W (2) - fällt im Betriebsfall circa 2,5V ab. Eine bidirektionale Leistungsschutzdiode (Transil) (22) begrenzt - zum Beispiel bei Überstrom - die Eingangsspannung auf circa 5V.

Die mittels der Regelschaltung (16) stabilisierte Eingangsgleichspannung wird über D₃/C₁ (23/24) einer zusätzlichen Glättung für den Fall der Auswertung von Blinksignalen unterzogen.

Die Ausgangsspannung des DC/DC-Wandlers (4) von konstant 5V dient der Stromversorgung der Meßschaltung (5). Des weiteren wird die Meßschaltung (5) mit der am Meßwiderstand Rₘ (1) abfallenden Meßspannung gegebenenfalls unter Zwischenschaltung eines Filters R₆/C₂ (25/26) beaufschlagt. Die Meßschaltung (5) kann dabei als Komparatorschaltung gemäß Figur 1 ausgebildet sein.

Die Erfindung beschränkt sich nicht auf die vorstehend angegebenen Ausführungsbeispiele. Vielmehr ist eine Anzahl von Varianten denkbar, welche auch bei grundsätzlich anders gearteter Ausführung von den Merkmalen der Erfindung Gebrauch machen. Insbesondere können anstelle analoger Bauelemente integrierte Schaltkreise verwendet werden.

## Patentansprüche

1. Schaltungsanordnung zur Strom-Schwellwerterkennung, insbesondere Lampenstrom-Schwellwerterkennung in der Eisenbahnsicherungstechnik, mit einem Meßwiderstand (Rₘ,1), dessen Spannungsabfall eine Eigen-Energieversorgung speist und mittels einer Meßschaltung (5) auswertbar ist, **dadurch gekennzeichnet, daß** der Meßwiderstand (Rₘ,1) auf einen Brückengleichrichter (B, 2) geschaltet ist, dessen Ausgänge mit einem Ladekondensator (C_{L}, 3) verbunden sind, der einen DC/DC-Wandler (4) zur Erzeugung einer stabilen Ausgangsspannung, beispielsweise +5V, zur Eigen-Energieversorgung speist.

2. Schaltungsanordnung nach Anspruch 1, **dadurch gekennzeichnet, daß** die Meßschaltung (5) einen Komparator (K, 8) aufweist, wobei der Ladekondensator (C_{L}, 3) über einen ersten Spannungsteiler (R₁/R₂, 9/10) mit einem ersten Eingang des Komparators (K, 8) verbunden ist, an dessen zweiten Eingang eine hoch stabile Referenzspannung, beispielsweise 1,21 V, anliegt, die von der Ausgangsspannung des DC/DC-Wandlers (4) unter Zwischenschaltung eines zweiten Spannungsteilers (R₃/Ref, 11/12), der eine Referenzdiode (Ref, 12) aufweist, abgeleitet ist.

3. Schaltungsanordnung nach einem der vorangehenden Ansprüche, **dadurch gekennzeichnet, daß** dem Ladekondensator (C_{L}, 3) eine Begrenzungsdiode (D_{B}, 7) parallel geschaltet ist.

4. Schaltungsanordnung nach einem der vorangehenden Ansprüche, **dadurch gekennzeichnet, daß** dem DC/DC-Wandler (4) eine Regelschaltung (16) zur Stabilisierung der Eingangsspannung des DC/DC-Wandlers (4) vorgeschaltet ist.

5. Schaltungsanordnung nach Anspruch 4, **dadurch gekennzeichnet, daß** die Regelschaltung (16) eine serielle Anordnung aus dem Meßstand (Rₘ, 1) und einem PNP-Transistor (Tr1, 17) umfaßt, welche mit einem Spannungsteiler (R₄/R₅, 18/19) und einer Diodenanordnung (D₁ und D₂, 20 und 21) einen Regelkreis bildet.

6. Schaltungsanordnung nach einem der vorangehenden Ansprüche, **dadurch gekennzeichnet, daß** am Eingang der Schaltung eine bidirektionale Leistungsschutzdiode (Transil, 22) zur Begrenzung der Eingangsspannung, beispielsweise auf 5V, vorgesehen ist.

7. Schaltungsanordnung nach einem der vorangehenden Ansprüche, **dadurch gekennzeichnet, daß** dem Meßwiderstand (Rₘ, 1) über einen Relaiskontakt (Kₚ, 15) ein Prüfwiderstand (Rₚ, 14) parallel schaltbar ist, der derart bemessen ist, daß der Schwellwert erreicht wird.

8. Schaltungsanordnung nach einem der vorangehenden Ansprüche, **dadurch gekennzeichnet, daß** das Ausgangssignal der Meßschaltung (5) einen Optokoppler (Ok, 13) beaufschlagt, der eine Auswerteelektronik ein- beziehungsweise ausschaltet.

9. Schaltungsanordnung nach einem der vorangehenden Ansprüche, **dadurch gekennzeichnet, daß** dem DC/DC-Wandler (4) eine Spannungsstabilisierungsschaltung (D₃/C₁, 23/24) für Blinksignale vorgeschaltet ist.

10. Schaltungsanordnung nach einem der vorangehenden Ansprüche, **dadurch gekennzeichnet, daß** die Meßschaltung (5) als DC-Frequenzumsetzer ausgebildett ist.

## Claims

1. Circuit configuration for current threshold recognition, particularly lamp current threshold recognition in railway signalling engineering, comprising a measurement resistor (Rₘ, 1), whose voltage drop feeds an internal electrical power supply and can be evaluated by means of a measurement circuit (5), **characterized in that** the measurement resistor (Rₘ, 1) is connected to a bridge rectifier (B, 2), whose outputs are connected to a charging capacitor (C_{L}, 3), which feeds a DC/DC converter (4) for the purpose of generating a stable output voltage, for example, +5 V, for the purpose of internal electrical power supply.

2. Circuit configuration according to claim 1, **characterized in that** the measurement circuit (5) has a comparator (K, 8), the charging capacitor (C_{L}, 3) being connected, via a first voltage divider (R₁/R₂, 9/10), to a first input of the comparator (K, 8) at whose second input there is present a highly stable reference voltage, for example, 1.21 V, which is derived from the output voltage of the DC/DC converter (4), a second voltage divider (R₃/Ref, 11/12), having a reference diode (Ref, 12), being interconnected.

3. Circuit configuration according to either of the preceding claims, **characterized in that** a limiter diode (D₈, 7) is connected in parallel with the charging capacitor (C_{L}, 3).

4. Circuit configuration according to any one of the preceding claims, **characterized in that** a regulating circuit (16), for stabilizing the input voltage of the DC/DC converter (4), is connected ahead of the DC/DC converter (4).

5. Circuit configuration according to claim 4, **characterized in that** the regulating circuit (16) comprises a serial arrangement which consists of the measurement stage (Rₘ, 1) and a PNP transistor (Tr1, 17) and which, together with a voltage divider (R₄/R₅, 18/19) and a diode arrangement (D₁ and D₂, 20 and 21), constitutes a regulating circuit.

6. Circuit configuration according to any one of the preceding claims, **characterized in that** a bidirectional circuit-breaking diode (Transil, 22) is provided, at the input of the circuit, for the purpose of limiting the input voltage, for example, to 5 V.

7. Circuit configuration according to any one of the preceding claims, **characterized in that** a testing resistor (Rₚ, 14), which is of such a rating that the threshold is attained, can be connected in parallel with the measurement resistor (Rₘ, 1), via a relay contact (Kₚ, 15).

8. Circuit configuration according to any one of the preceding claims, **characterized in that** the output signal of the measurement circuit (5) is supplied to an optocoupler (Ok, 13), which switches an electronic evaluation system on and off.

9. Circuit configuration according to any one of the preceding claims, **characterized in that** a voltage stabilization circuit (D₃/C₁, 23/24) for intermittent signals is connected ahead of the DC/DC converter (4).

10. Circuit configuration according to any one of the preceding claims, **characterized in that** the measurement circuit (5) is designed as a DC frequency converter.

## Revendications

1. Agencement de circuit pour la détection de seuil de courant, en particulier la détection de seuil de courant de lampe dans la technique de signalisation ferroviaire, comprenant une résistance de mesure (Rₘ, 1), dont la chute de tension alimente une alimentation propre en énergie et peut être analysée au moyen d'un circuit de mesure (5), **caractérisé en ce que** la résistance de mesure (Rₘ, 1) est commutée sur un redresseur en pont (B, 2), dont les sorties sont reliées à un condensateur de lissage (C_{L}, 3), qui alimente un convertisseur à courant continu (4) pour la génération d'une tension de sortie stable, par exemple +5 V, pour l'alimentation propre en énergie.

2. Agencement de circuit selon la revendication 1, **caractérisé en ce que** le circuit de mesure (5) présente un comparateur (K, 8), le condensateur de lissage (C_{L}, 3) étant relié au moyen d'un premier diviseur de tension (R₁/R₂, 9/10) à une première entrée du comparateur (K, 8), sur la seconde entrée duquel est appliquée une tension de référence très stable, par exemple 1,21 V, qui est dérivée de la tension de sortie du convertisseur à courant continu (4) avec l'intercalation d'un second diviseur de tension (R₃/Réf, 11/12), qui présente une diode de référence (Ref, 12).

3. Agencement de circuit selon l'une quelconque des revendications précédentes, **caractérisé en ce qu'**une diode de limitation (D₈, 7) est commutée parallèlement au condensateur de lissage (C_{L}, 3).

4. Agencement de circuit selon l'une quelconque des revendications précédentes, **caractérisé en ce qu'**un circuit de réglage (16) est monté en amont du convertisseur à courant continu (4) pour la stabilisation de la tension d'entrée du convertisseur à courant continu (4).

5. Agencement de circuit selon la revendication 4, **caractérisé en ce que** le circuit de réglage (16) comprend un dispositif de série constitué du poste de mesure (Rₘ, 1) et d'un transistor p-n-p (Tr1, 17), qui forme avec un diviseur de tension (R₄/R₅, 18/19) et un agencement de diodes (D₁ et D₂, 20 et 21) un circuit de réglage.

6. Agencement de circuit selon l'une quelconque des revendications précédentes, **caractérisé en ce qu'**il est prévu sur l'entrée du circuit une diode de protection de puissance bidirectionnelle (Transil, 22) pour la limitation de la tension d'entrée, par exemple à 5 V.

7. Agencement de circuit selon l'une quelconque des revendications précédentes, **caractérisé en ce qu'**une résistance d'essai (R_{P}, 14), qui est dimensionnée de telle sorte que la valeur seuil est atteinte, peut être commutée parallèlement à la résistance de mesure (Rₘ, 1) au moyen d'un contact de relais (K_{P}, 15).

8. Agencement de circuit selon l'une quelconque des revendications précédentes, **caractérisé en ce que** le signal de sortie du circuit de mesure (5) alimente un optocoupleur (Ok, 13) qui enclenche ou déconnecte une électronique d'analyse.

9. Agencement de circuit selon l'une quelconque des revendications précédentes, **caractérisé en ce qu'**un circuit de stabilisation de tension (D₃/C₁, 23/24) pour des signaux clignotants est placé en amont du convertisseur à courant continu (4).

10. Agencement de circuit selon l'une quelconque des revendications précédentes, **caractérisé en ce que** le circuit de mesure (5) est conçu comme un convertisseur de fréquence à courant continu.
